Europäisches Patentamt

European Patent Office

Office européen des brevets

(11) Numéro de publication: **0 086 728**
**B1**

(12) **FASCICULE DE BREVET EUROPEEN**

(45) Date de publication du fascicule du brevet: **01.06.88**

(21) Numéro de dépôt: **83420018.0**

(22) Date de dépôt: **03.02.83**

(51) Int. Cl.⁴: **F 16 J 15/16**

(54) Dispositif pour l'introduction et/ou le retrait, d'une manière étanche, de solides à travers au moins un orifice d'une enceinte de traitement à basse pression notamment.

(30) Priorité: **11.02.82 FR 8202717**

(43) Date de publication de la demande:
**24.08.83 Bulletin 83/34**

(45) Mention de la délivrance du brevet:
**01.06.88 Bulletin 88/22**

(84) Etats contractants désignés:
**AT BE CH DE GB IT LI LU NL SE**

(56) Documents cités:
**US-A-2 509 699**
**US-A-2 661 619**
**US-A-2 853 970**
**US-A-3 055 080**
**US-A-3 240 037**
**US-A-3 868 104**

(73) Titulaire: **CENTRE STEPHANOIS DE RECHERCHES MECANIQUES HYDROMECANIQUE ET FROTTEMENT Société dite:**
**Zone Industrielle Sud Rue Benoît Fourneyron**
**F-42160 Andrezieux Boutheon (FR)**

(72) Inventeur: **Lacour, Gilles**
**24 rue Lamartine**
**F-42160 Andrezieux-Boutheon (FR)**
Inventeur: **Esteveny, Serge**
**38bis rue Gambetta**
**F-42170 St.Just-St.Rambert (FR)**

(74) Mandataire: **Dupuis, François**
**Cabinet Charras 3 Place de l'Hôtel-de-Ville**
**F-42000 St.Etienne (FR)**

Courier Press, Leamington Spa, England.

## Description

Dispositif pour l'introduction et/ou le retrait, d'une manière étanche, de solides à travers au moins un orifice d'une enceinte de traitement à basse pression notamment.

L'objet de l'invention se rattache notamment au secteur technique de la technologie en général et plus particulièrement à la dynamique des fluides.

De nombreux traitements de surface modernes se font dans des enceintes dans lesquelles est ménagé un vide plus ou moins poussé. Il existe des traitements qui s'opèrent avec un vide de l'ordre de 1,333 Pascal, tels que les traitements en phase vapeur, ou de l'ordre de $1,333.10^{-1}$ Pascal, c'est le cas par exemple des dépôts de nitrure de titane par pulvérisation...

Actuellement, les machines à traiter sous vide sont discontinues. D'une manière générale, elles présentent une série de chambres où peuvent règner des hauteurs de vide différentes, lesdites chambres étant susceptibles successivement, de décaper, traiter, sécher, refroidir, etc... Chaque opération successive est caractérisée par l'ouverture simultanée d'un ensemble de vannes qui séparent les enceintes deux par deux, et par une avancée de toute la chaîne de traitement, égale à la longueur modulaire d'une enceinte. Après chaque fermeture de vanne, les ensembles de pompes à vide entrent en action pour rétablir la pression désirée.

De tels systèmes sont mal adaptés à des produits longs ou à des produits continus, solides, tels que les fils ou les tôles. Lorsque le solide circule entre deux enceintes consécutives, les différences de pression de part et d'autre de la paroi étant relativement faibles, on peut se contenter d'un simple orifice de communication, le débit de pompe compensant les fuites d'une enceinte à l'autre. Mais, le problème est différent lorsque le solide doit passer de l'extérieur dans la première enceinte, ou de la dernière enceinte vers l'extérieur. Dans ce cas, les systèmes classiques connus présentent tous des inconvénients, le plus souvent rédhibitoires.

C'est notamment le cas pour les opérations et traitement suivants:

— lorsque l'on désire un jeu aussi faible que possible entre le fil, ou la tôle, et l'orifice de sortie, il se produit un raclage du produit contre la paroi. Si les marques ou griffures qui en résultent sont tolérables avant le traitement du produit, elles sont rédhibitoires après le traitement lors de la sortie du produit.

— Si l'on veut faire frotter le produit, long ou continu, à l'intérieur d'un sphincter élastique, on se heurte alors, dès que les pressions descendent en-dessous de quelques dizaines de torrs, à d'autres inconvénients, parmi lesquels: dégazage du produit, tension de vapeur saturante, tenue à la chaleur ou au froid, pollution de la surface du produit traité, etc...

— Dans le cas où l'on veut faire passer le produit à travers un conduit avec un jeu suffisamment large pour éviter le contact et si l'on ménage différents décrochements, chacun muni d'une aspiration, il apparaît alors obligatoire d'installer une puissance excessive. De plus, dans le cas d'un produit continu, qui se rompe accidentellement, le réenfilage automatique dudit produit, sans arrêter la chaîne, s'avère compliqué et peu commode.

— On a également proposé d'obtenir une étanchéité, au moins partielle, par des ferrofluides. On se heurte toutefois, tantôt à la tension de vapeur saturante de la partie liquide de ferrofluide, tantôt au magnétisme du produit; par exemple, on ne peut obtenir une étanchéité avec des ferrofluides soumis à un champ magnétique si le produit est à base de fer.

Dans le brevet US 2.509.699 qui décrit un appareil avec une partie formant convergent et une partie formant divergent, pour le refroidissement de longueurs continues d'articles vulcanisés filamentaires, il apparaît des risques de rétrodiffusion de la vapeur. A la sortie de l'appareil, le produit traité n'est pas entièrement sec. L'étanchéité ne peut être assurée suite à un décrochage dynamique résultant de l'absence d'une partie formant col entre le convergent et le divergent de l'appareil.

Selon l'invention, pour remédier à ces différents inconvénients, on a réalisé, d'une manière particulièrement simple et efficace, un dispositif qui permet l'introduction et/ou le retrait, d'une manière parfaitement étanche, de solides à travers au moins un orifice d'une enceinte de traitement dont la pression interne est inférieure à celle de l'environnement immédiat.

Dans ce but, le dispositif tel que caractérisé dans les revendications, comprend un tube de venturi constituant intérieurement un convergent et un divergent, ledit tube étant relié du côté du convergent, à un manchon agencé et équipé pour permettre l'injection d'un fluide sous pression et son écoulement en direction de l'intérieur du tube de venturi; ledit manchon, susceptible d'être accouplé à l'enceinte, cuve à basse pression ou autre, présentant intérieurement, directement ou d'une manière rapportée, un fourreau axial d'introduction et de communication entre l'orifice de ladite enceinte ou autre et le tube de venturi; ledit fourreau étant engagé partiellement à l'intérieur du tube venturi au niveau d'une partie située entre le convergent et le divergent en constituant un col, de façon à créer, à ce niveau, un changement brusque de section qui a pour effet de définir une zone de joint dynamique en combinaison avec les pressions, débit et vitesse du fluide injecté en direction de l'intérieur du tube venturi, le ou les solides étant susceptibles d'être engagés ou retirer du côté du divergent à l'intérieur du fourreau de communication pour être introduits totalement secs à l'intérieur de l'enceinte.

Les avantages obtenus grâce à l'invention sont remarquable de part:
— la simplicité du dispositif,
— l'étanchéité stable et complète réalisée entre l'environnement et l'enceinte de traitement,
— les produits introduits dans le dispositif, du côté du divergent, arrivent dans la cuve à basse pression totalement secs évitant ainsi l'emploi de moyens auxiliaires onéreux et complexes.

L'invention est exposée ci-après plus en détail à l'aide des dessins annexés, dans lesquels:

— les figures 1, 2 et 3 sont des vues à caractère purement schématique montrant, selon trois variantes de réalisation, le principe de l'écoulement fluidique applicable au dispositif de l'invention,

— la figure 4 est une vue en coupe longitudinale d'un exemple nullement limitatif de réalisation du dispositif,

— la figure 5 est une vue en coupe transversale considérée selon la ligne 5.5 de la figure 4.

— les figures 6 et 7 montrent, par des vues schématiques, deux exemples d'application possibles du dispositif,

— la figure 8 est une schématique montrant un traitement chimique du fil selon l'art antérieur,

— la figure 9 montre le traitement chimique d'un fil avec application du dispositif selon l'invention.

Afin de rendre plus concret l'objet de l'invention, on le décrit maintenant d'une manière non limitative en se référant aux exemples de réalisation des figures des dessins.

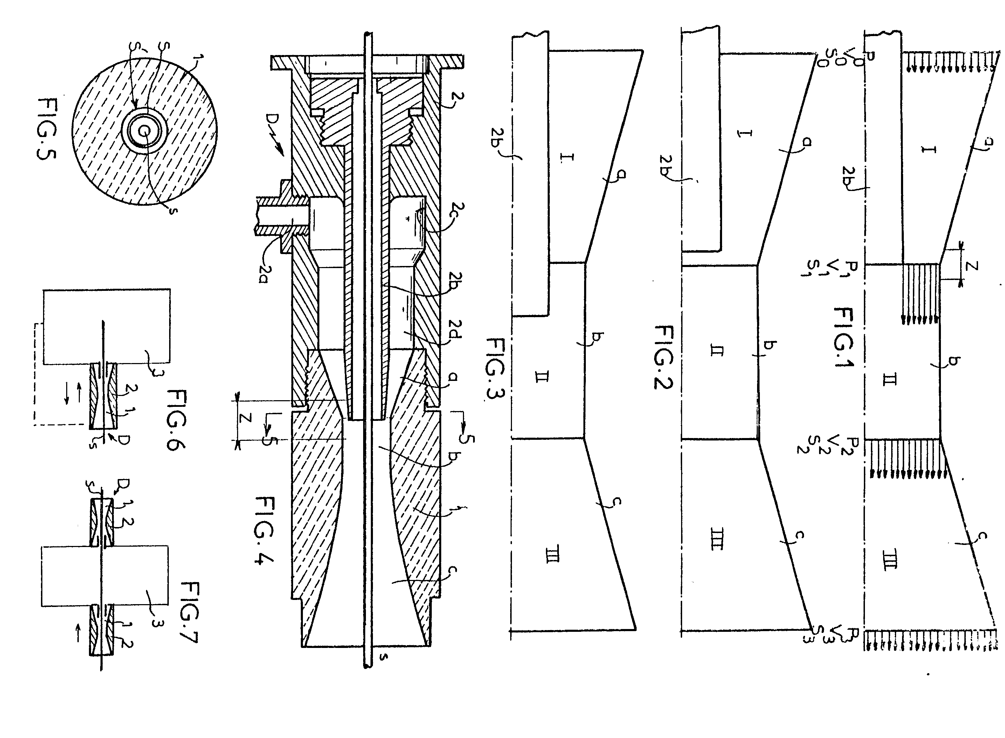

Selon l'invention, comme le montrent notamment les figures 1, 2 et 3, on a voulu utiliser le principe des trompes à fluides pour une application nouvelle comme joints immatériels d'étanchéité. Dans le cas d'un écoulement laminaire, on peut modeliser de la manière suivante: le fluide partant d'une pression initale ($P_0$), d'une vitesse ($V_0$), passe par une pression nulle, ou sensiblement nulle, au niveau d'un élargissement brusque de section pour remonter à la pression atmosphérique à la sortie. Dans ce but, l'écoulement est partagé en trois parties respectivement I, II, et III.

Dans la première partie I (figure 1), un convergent (a), qui sert à mettre le fluide en mouvement, transforme l'énergie de pression dudit fluide en énergie cinétique. Dans la partie II, qui correspond à un col (b) produit le changement brusque de section; le fluide, initialement dans la section ($S_0$), à la vitesse ($V_0$), et à la pression ($P_0$), passe brusquement dans une section ($S_1$) à une vitesse ($V_1$) et à une pression ($P_1$) très sensiblement nulle. On considère une perte d'énergie par chocs.

Dans la troisième partie III, un divergent (c) transforme l'énergie cinétique en énergie potentielle de pression. De la section ($S_2$) à la section ($S_3$), à la sortie du divergent (c), le fluide passe de la vitesse ($V_2$) à la vitesse ($V_3$) et de la pression ($P_2$) à la pression ($P_3$) correspondant sensiblement à la pression atmosphérique.

On remarque que le changement brusque de section peut s'effectuer soit au niveau de la partie de raccordement du convergent (a) et du col (b) (figure 1), soit en amont du col (b) (figure 2), soit sur une partie de la longueur du col (b) (figure 3).

D'une manière préférée, le changement brusque de section n'est pas provoqué dans le divergent (c), car cela nuirait au rendement.

Au niveau de ce changement brusque de section, il se produit, en combinaison avec l'écoulement fluidique, une zone (Z) correspondant à une zone de joint dynamique. Ce phénomène physique s'avère particulièrement important et avantageux pour faire circuler un produit solide (un fil par exemple) d'un endroit quelconque à une pression ($P_3$) dans, par exemple, une enceinte dont la pression ($P_0$) est inférieure et cela avec une étanchéité stable et complète, entre les deux.

Il convient maintenant de se référer à la figure 4 qui montre un exemple nullement limitatif de réalisation du dispositif qui met en oeuvre les principes fondamentaux éconcés ci-dessus.

Le dispositif comprend pour l'essentiel, un tube de venturi (1) qui constitue intérieurement et successivement le convergent (a), le col (b) et le divergent (c). Ce tube de venturi (1) est solidaire, d'une manière démontable ou non, du côté du convergent (a), d'un manchon d'accouplement (2) conformé extérieurement en (2a) pour permettre l'injection d'un fluide sans pression et son écoulement laminaire en direction du tube de venturi (1).

Le manchon (2) présente intérieurement, directement ou d'une manière rapportée, un fourreau axial (2b) de communication entre le tube de venturi (1) et par exemple une enceinte (3) à laquelle est susceptible d'être raccordé le manchon (2). Le fourreau (2b) coopère avec le convergent (a), au niveau du col (b) comme indiqué précédemment, de façon à créer à ce niveau le changement brusque de section. Il en résulte donc la zone de joint dynamique (Z).

La périphérie externe du fourreau (2b), en combinaison avec la paroi interne (2c) du manchon, constitue une chambre annulaire (2d) qui communique avec le convergent (a) pour l'écoulement et l'introduction du fluide dans le tube de venturi.

D'une manière importante, non indispensable mais fortement recommandé, la section extérieure (S) de l'extrémité du fourreau (2) au niveau du col (b) ainsi que la section (S') dudit col (b) au droit de l'extrémité du fourreau, doivent être convenablement dimensionnées en combinaison avec la section (s) du solide à introduire (figure 5). Il faut que l'efficacité du système (S et S') (c'est-à-dire sans le solide), soit la même que l'efficacité du système (S et (S' − s)) pour que les rapports S et S soient équivalents en vue de conduire au même coefficient de saut de pression lors de la convertion de l'énergie. On se fixe ainsi un minimum de performances quelles que soient les conditions.

Ainsi réalisé, le dispositif est particulièrement bien adapté pour faire entrer et/ou sortir, d'une manière totalement étanche, des solides à travers un orifice (o) d'une enceinte de traitement (3) dont la pression ($P_0$) est inférieure à celle de l'environnement immédiat ($P_3$) qui peut être une autre enceinte ou la pression atmosphérique.

Le ou les solides, des fils par exemple, sont susceptibles d'être introduits du côté du divergent (c), c'est-à-dire au niveau de pression ($P_3$), pour être engagés sans frottement dans l'alésage du fourreau (2) en vue d'être introduits par l'orifice (o) dans l'enceinte (3) à la pression (P$_o$) pour y subir divers traitements selon les applications spécifiques recherchées. La zone de joint dynamique créée permet à l'enceinte (3) de n'être polluée ni par le dispositif, ni par l'environnement.

De plus, on observe d'une manière particulièrement importante, que le ou les solides entrés dans le dispositif et/ou le divergent (c), arrivent dans la cuve de traitement entièrement secs et exempts de toutes impuretés, ce qui évidement offre des avantages considérables.

Selon les cas d'applications, le dispositif (D) peut par exemple, être monté comme indiqué, d'un seul côté de l'enceinte (3) (figure 6), les solides étant introduits (manuellement, automatiquement, ou par tout moyen approprié), du même côté du divergent (C).

Ou bien pour un traitement en continu des solides, l'enceinte peut être équipée de deux dispositifs conformes à l'invention et situés sur un même alignement axial (figure 7), l'un des dispositifs correspondant à l'entrée des solides, l'autre à la sortie. Le manchon (2), à l'opposé du divergent (c) est toujours situé du côté basse pression (enceinte par exemple).

Il est bien évident que selon les lois de la dynamique des fluides, les différents paramètres sont calculés de façon qu'il n'y ait pas de cheminement possible du fluide de l'extérieur vers l'intérieur de l'enceinte.

Le fluide injecté peut être de l'eau, de l'huile ou autre...

De même, le manchon (2) peut présenter intérieurement divers agencements par exemple pour rendre réglable en position linéaire le fourreau de communication, permettre le guidage des solides, etc...

Ainsi réalisé, l'invention trouve des applications particulièrement avantageuse pour les traitements sous vide, ainsi que pour les traitements de surface chimique ou électrochimique de solides allongés tels que: fils, profilés, tôles, etc...

Dans ce dernier cas spécifique d'application aux traitements chimiques ou électrochimiques, le dispositif apporte des avantages très importants par rapport aux techniques connues actuellement employées. Généralement, comme le montre très schématiquement la figure 8, le fil à traiter (F) devait suivre un cheminement spécial pour passer d'une cuve (A) à l'autre en vue de subir les différents traitements nécessaires (dégraissage, prérinçage, rinçage, dépassivation, dépôt galvanique...).

Le dispositif selon l'invention permet notamment de supprimer ce cheminement complexe du fil et d'augmenter d'une manière relativement importante le traitement, puisque selon l'art antérieur, à titre indicatif, on était capable de traiter très sensiblement sous 1A/dm$^2$ alors que l'application du dispositif avec une agitation très intense, permet d'atteindre 5 à 10 A/dm$^2$.

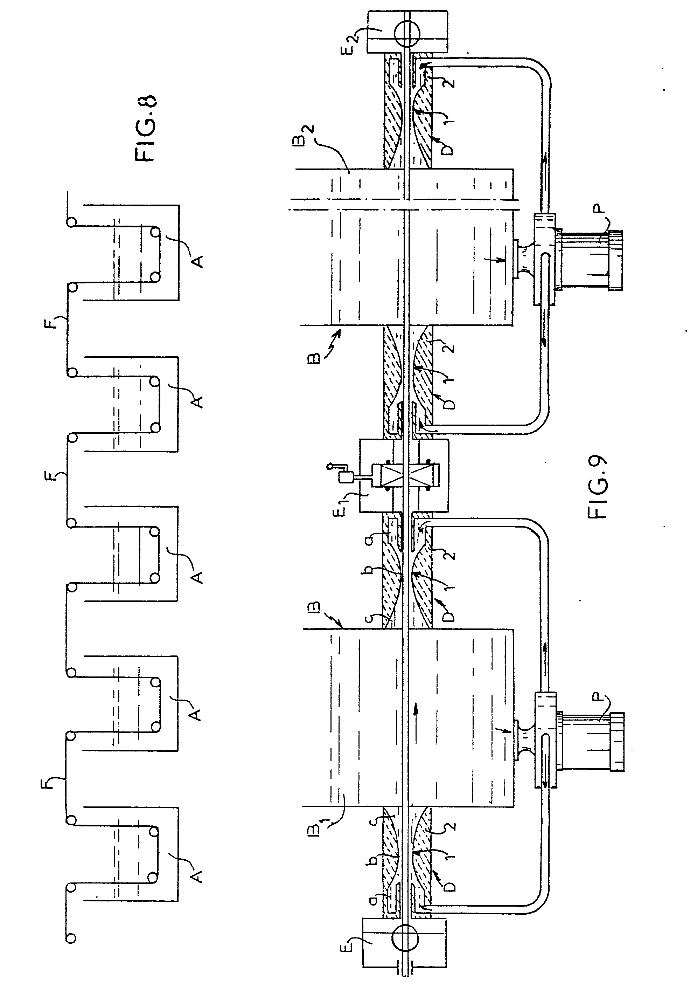

La figure 9 montre à titre d'exemple nullement limitatif, une installation pour l'application du dispositif à un traitement chimique ou électrochimique.

L'installation comprend évidement plusieurs cuves de traitement désignées dans leur ensemble par (B).

A l'entrée de la première cuve (B1) est monté le dispositif (D) relié du côté du convergent, à une enceinte basse pression (E) dont l'orifice d'entrée calibré fait office de perte de charges. Entre chacune des cuves suivantes sont montés, d'une manière opposée, deux ensembles tube de venturi (1) — fourreau (2), les convergents de chacun desdits ensembles étant accouplés par une chambre commune à basse pression (E1). On souligne que la chambre basse pression (E1) peut être équipée d'un boisseau d'électrovanne et d'un moyen de commande des fuites d'équilibrage des tensions de vapeur.

La dernière cuve (B2) à sa sortie, de la même façon que la première cuve (B1) à son entrée, est équipée d'un ensemble tube de venturi (1) — fourreau (2) dont le convergent est relié à une enceinte basse pression (E2). Les convergents de chacun des ensembles venturi (1) — fourreau (2), sont convenablement accouplés à des moyens de pompage (P) relatifs à chacune des cuves correspondantes.

Le fil ou autre solide à traiter, peut donc être introduit, traité et retiré de la première à la dernière cuve, d'une manière totalement linéaire en opposition aux systèmes connus.

On prévoit également l'association et la combinaison de plusieurs dispositifs conformes à l'invention de façon à rendre le système encore plus efficace par accumulation des avantages de chacun des dispositifs pris séparément.

Cette association peut s'effectuer soit en combinant n dispositifs montés en série, soit par n groupes de deux dispositifs montés en opposition.

**Revendications**

1. Dispositif pour l'introduction et/ou le retrait de solides à travers au moins un orifice d'une enceinte de traitement, cuve à basse pression ou autre, dont la pression est inférieure à celle de l'environnement immédiat, comprenant pour l'essentiel, un tube de Venturi (1) constituant intérieurement une partie faisant office de convergent (a) et une partie faisant office de divergent (c), ledit tube (1) étant relié, du côté du convergent (a), à un manchon (2) agencé et équipé pour permettre l'injection d'un fluide sous pression et son écoulement en direction de l'intérieur du tube de Venturi (1), caractérisé en ce que ledit manchon (2), susceptible d'être accouplé à l'enceinte, cuve à basse pression, ou autre, présentant intérieurement, directement ou d'une manière rapportée, un fourreau axial (2b) d'introduction et de communication entre l'orifice de ladite enceinte ou autre et le tube de Venturi (1), le fourreau (2b) étant engagé partiellement à l'intérieur dudit tube de Venturi au niveau d'une partie située entre le convergent et le divergent en constituant un col, de façon à créer, à ce niveau, un changement brusque de section qui a pour effet de définir une zone (Z) de joint dynamique en combinaison avec les pressions, débit et vitesse du fluide injecté en direction de l'intérieur du tube de Venturi; le ou les solides étant susceptibles d'être engagés ou retirés du côté du divergent (c) du tube de Venturi (1), à l'intérieur du fourreau de communication (2b) pour être introduits totalement secs dans l'enceinte ou autre.

2. Dispositif selon la revendication 1, caractérisé en ce que la section externe (S) de l'extrémité du fourreau (2b) à l'intérieur du tube de Venturi (1), ainsi que la section interne (S') du Venturi, au droit de l'extrémité dudit fourreau, sont dimensionées en combinaison avec la section (s) du ou des solides à introduire, de façon à ce que l'efficacité du système (S) et (S') soit la même que l'efficacité du système (s) et (S' −S), en vue de conduire au même coéfficient de saut de pression lors de la conversion de l'énergie.

3. Dispositif selon la revendication 1, caractérisé en ce que le fluide, sensiblement à l'entrée du convergent (a), est à une pression initiale et à une vitesse initiale déterminées pour passer par une pression nulle ou sensiblement nulle au niveau d'un élargissement brusque de section créé par l'extrémité du fourreau (2b) et pour remonter à la pression atmosphérique à la sortie du divergent (c).

4. Dispositif selon la revendication 1, caractérisé en ce que le fourreau (2b) est engagé dans le tube de Venturi, suivant une longueur telle que le changement brusque de section s'effectue au niveau de la partie de raccordement du convergent (a) et du col (b).

5. Dispositif selon la revendication 1, caractérisé en ce que le fourreau (2b) est engagé dans le tube de Venturi (1) suivant une longueur telle que le changement brusque de section s'effectue en amont du col (b), dans le convergent.

6. Dispositif selon la revendication 1, caractérisé en ce que le fourreau (2b) est engagé dans le tube de Venturi (1) suivant une longueur telle que le changement brusque de section s'effectue sur une partie de la longueur du col (b).

7. Dispositif selon la revendication 1 et son application aux traitements chimiques ou électrochimiques de solides, au moyen d'une série de cuves de traitement, la première desdites cuves étant accouplés à l'ensemble tube de Venturi (1) — fourreau (2b) dont le convergent est relié à une chambre à basse pression, chacune des autres cuves étant en communication par deux ensembles tubes de Venturi (1) — fourreau (2b), montés en opposition et dont les convergents sont accouplés par l'intermédiaire d'une chambre commune basse pression, tandis que la dernière cuve, en fin de traitement, est reliée à un autre ensemble tube de Venturi (1) — fourreau (2b), dont le convergent est relié à une chambre basse pression; les convergents de chacun des ensembles Venturi (1) —

fourreau (2b) étant convenablement accouplés à des moyens de pompage relatifs à chacune des cuves correspondantes.

8. Dispositif selon la revendication 1 et l'association de plusieurs ensembles tube de Venturi (1) — fourreau (2b), en combinant un certain nombre d'ensembles montés en série ou en combinant un certain nombre de groupes de deux ensembles montés en opposition.

## Patentansprüche

1. Vorrichtung für die Einführung und/oder das Herausnehmen von Feststoffen durch am wenigstens eine Offnung hindurch eines Behandlungsgehäuses, eines Tiefdruckbehälters oder desgleichen, dessen Druck niedriger als der Druck der unmittelbaren Umgebung ist, die in der Hauptsache ein Venturirohr (1) aufweist, das innenseitig einen als Konvergierteil (a) dienenden Abschnitt und einen als Divergierteil (c) dienenden Abschnitt bildet, wobei das besagte Rohr (1), nach der Seite des Divergierteils (a), mit einer Hülle (2) verbunden ist, die für die Einspritzung einer Druckflüssigkeit und das Abfliessen derselben in der Richtung der Innenseite des Venturirohrs (1) eingerichtet und ausgestattet ist, dadurch gekennzeichnet, dass die zur Kupplung mit dem Gehäuse, Tiefdruckbehälter oder desgleichen geeignete Hülle (2) eine zur Einführung und zum Anschluss zwischen der Öffnung des besagten Gehäuses oder desgleichen vorgesehene, achsrechte Scheide (2b) unmittelbar oder angebaut innenseitig aufweist; dass die Scheide (2b) in die Innenseite des Venturirohrs an der Höhe eines zwischen dem Konvergierteil und dem Divergierteils, einen Hals bildenden, befindlichen Teils teilweise eingreift, um an dieser Höhe eine scharfe Abschnittänderung zu schaffen, wobei ein dynamischer Dichtungsbereich (Z) in Kombination mit den Druckwerten, der Liefermenge und der Geschwindigkeit der in der Richtung der Innenseite des Venturirohrs eingespritzten Flüssigkeit bestimmt wird; und dass der Feststoff oder die Feststoffe nach der Seite des Divergierteils (c) des Venturirohrs (1) in die Innenseite der Anschlusscheide (2b) eingeführt oder daraus herausgenommen werden können, damit sie völlig ausgetrocknet in das Gehäuse oder desgelichen eingeführt werden.

2. Vorrichtung nach Anspruch 1, dadurch gekennzeichnet, dass der Aussenabschnitt (S) des Endes der Scheide (2b), in der Innenseite des Venturirohrs (1), sowie der Innenabschnitt (S') des Venturi, rechtwinklig zum Ende der besagten Scheide, in Kombination mit dem Querschnitt (s) des oder der einzuführenden Feststoffen bemessen sind, sodass die Leistungsfähigkeit des Systems (S) und (S') die gleiche wie die Leistungsfähigkeit des Systems (s) und (S' − S) verbleibt, um den gleichen Drucksprungskoeffizienten bei der Umwandlung der Energie zu erreichen.

3. Vorrichtung nach Anspruch 1, dadurch gekennzeichnet, dass die Flüssigkeit, etwa bei dem Eintritt des Konvergierteils (a), durch einen Anfangsdruck beaufschlagt und mit einer Anfangsgeschwindigkeit bewegt wird, die zum Übergehen durch einen Nulldruck oder etwa einen Nulldruck an der Höhe einer durch das Ende der Scheide (2b) verursachten, plötzlichen Querschnitterweiterung und zum Wiederaufsteigen bis zum atmosphärischen Druck bei dem Austritt des Divergierteils (c) bestimmt und vorgesehen sind.

4. Vorrichtung nach Anspruch 1, dadurch gekennzeichnet, dass die Scheide (2b) in das Venturirohr auf einer Länge eingreift, die so bemessen ist, dass die plötzliche Querschnittveränderung an der Höhe des Verbindungsteils des Konvergierteils (a) und des Halses (b) stattfindet.

5. Vorrichtung nach Anspruch 1, dadurch gekennzeichnet, dass die Scheide (2b) in das Venturirohr (1) auf einer Länge eingreift, die so bemessen ist, dass die plötzliche Querschnittveränderung vor dem Hals (b), in den Konvergierteil, stattfindet.

6. Vorrichtung nach Anspruch 1, dadurch gekennzeichnet, dass die Scheide (2b) in das Venturirohr (1) auf einer Länge eingreift, die so bemessen ist, dass die plötzliche Querschnittveränderung auf einem Teil des Halses (b) stattfindet.

7. Vorrichtung nach Anspruch 1 und die Anwendung derselben für die chemischen oder elektrochemischen Behandlung von Feststoffen vermittels einer Reihe von Behandlungsbehältern, dadurch gekennzeichnet, dass der erste der genannten Behälter mit dem Venturirohr (1) — Scheide (2b) — Komplex zusammengekuppelt ist, dessen Konvergierteil mit einer Tiefdruckkammer verbunden ist; dass jeder eine der anderen Behälter durch zwei entgegengesetzt montierten Venturirohr (1) — Scheide (2b) — Komplexe in Verbindung stehen, derer Konvergierteile vermittels einer gemeinsamen Tiefdruckkammer zusammengekuppelt sind; un dass der letzte Behälter, am Ende des Behandlungsverfahrens, mit einem anderen Venturirohr (1) — Scheide (2b) — Komplex verbunden ist, dessen Konvergierteil an eine Tiefdruckkammer angeschlossen wird, wobei die Konvergierteile jedes einen der Venturi (1) — Scheide (2b) — Komplexe in geeigneter Weise mit Pumpeneinrichtungen zusammengekuppelt sind, die jedem einen der entsprechenden Behälter zugeordnet sind.

8. Vorrichtung nach Anspruch 1 und die Zusammensetzung mehrerer Venturirohr (1) — Scheide (2b) — Komplexe, bei der Kombination einer Anzahl serienmontierter Komplex, oder bei der Kombination einer Anzahl von Gruppen, die aus zwei entgegengesetzt montierten Komplexen bestehen.

**Claims**

1. A device for the introduction and/or the removal solids through at least one orifice of a processing enclosure, which may be a low pressure tank or the like, the pressure of which is lower than the pressure of the immediate environment, comprising chiefly a Venturi tube (1) which constitutes internally a convergent-like part (a), and a divergent-like part (c), said tube (1) being connected on the side of the convergent (a) with a sleeve (2) arranged and equipped for permitting the injection of a fluid under pressure and the flow thereof in the direction of the inside of the Venturi tube (1), the device being characterized in that said sleeve (2) is capable of being coupled with the enclosure, low pressure tank or the like, and is provided internally, directly or in an inserted manner, with an axial sheathing (2b) for introduction and communication between the orifice of said enclosure or the like and the Venturi tube (1), the sheathing (2b) being engaged partly within the inside of said Venturi tube at the level of a portion located between the convergent and the divergent and forming a neck, so that there will be provided at this level a sudden change in section, the effect of which is to define a dynamic sealing area (Z) in combination with the pressures, flow and velocity of the fluid injected in the direction of the inside of the Venturi tube, the solid or solids being capable of being engaged or removed on the side of the divergent (c) of the Venturi tube (1), within the interior of the sheathing of communication (2b) to be introduced entirely dried up within the enclosure or the like.

2. A device as claimed in Claim 1, characterized in that the external section (S) of the end of the sheathing (2b) within the interior of the Venturi tube (1), as well as the internal section (S') of the Venturi, at right side to the end of said sheathing, are dimensioned in combination with the section (s) of the solid or solids to be introduced, so that the efficiency of the system (S) and (S') will be the same as the efficiency of the system (s) and (S' − S), in order to lead to the same factor of change in pressure at the time of the conversion of the energy.

3. A device as claimed in Claim 1, characterized in that the fluid, practically at the inlet of the convergent (a), is under an initial pressure and at an initial velocity which are set for passing through a zero pressure or practically a zero pressure at the level of a sudden section widening produced by the end of the sheathing (2b) and for rising up again to the atmospheric pressure at the outlet of the divergent (c).

4. A device as claimed in Claim 1, characterized in that the sheathing (2b) is engaged within the Venturi tube (1) along a length which is such that the sudden change in section will take place at the level of the connecting portion of the convergent (a) and of the neck (b).

5. A device as claimed in Claim 1, characterized in that the sheathing (2b) is engaged within the Venturi tube (1) along a length which is such that the sudden change in section will take place ahead of the neck (b), within the convergent.

6. A device as claimed in Claim 1, characterized in that the sheathing (2b) is engaged within the Venturi tube (1) along a length which is such that the sudden change in section will take place on a portion of the length of the neck (b).

7. A device as claimed in Claim 1, and the use thereof for the chemical or electrochemical processings of solids, by means of a range of processing vessels, the first one of said vessels being coupled to the unit consisting of the Venturi tube (1) and of the sheathing (2b), the convergent of which is connected with a low pressure chamber, each one of the other vessels being in communication by means of two such Venturi tube (1) — sheathing (2b) units mounted in opposite relation, the convergents of which are coupled through the intermediary of a common low pressure chamber, while the last vessel, at the completion of the processing, is connected with a further Venturi tube (1) — sheathing (2b) unit, the convergent of which is connected with a low pressure chamber, the convergents of each one of the Venturi (1) — sheathing (2b) unit being suitably coupled to pumping means corresponding to each one of the respective vessels.

8. A device as claimed in Claim 1 and the association of a plurality of Venturi tube (1) — sheathing (2b) units, in combination with a number of assemblies connected in series or in combination with a number of groups or two assemblies mounted in opposite relation.

FIG.1

FIG.2

FIG.3

FIG.4

FIG.5

FIG.6

FIG.7

FIG.8

FIG.9

0 086 728